Europäisches Patentamt

European Patent Office

Office européen des brevets

(11) Publication number: **0 351 109**
**A2**

## (12) EUROPEAN PATENT APPLICATION

(21) Application number: **89306654.8**

(51) Int. Cl.⁴: **G06F 11/00**

(22) Date of filing: **30.06.89**

(30) Priority: **11.07.88 US 217451**

(43) Date of publication of application:
**17.01.90 Bulletin 90/03**

(84) Designated Contracting States:
**AT CH DE ES FR GB IT LI NL**

(71) Applicant: **AMDAHL CORPORATION**
**1250 East Arques Avenue**
**Sunnyvale California 94088-3470(US)**

(72) Inventor: **Schneider, Frederick W.**
**555 West Middlefield No.S308**
**Mountain View California 94043(US)**

(74) Representative: **Crawford, Andrew Birkby et al**
**A.A. THORNTON & CO. Northumberland**
**House 303-306 High Holborn**
**London WC1V 7LE(GB)**

(54) Reducing resources in a high reliability data storage subsystem.

(57) To improve data reliability in a computer system, at least one primary copy and one secndary duplicate copy of data are stored each in a different storage devices having similar access characteristics. Periodically, a copy of the data is logged into an archival device. The secondary copy is then removed from the storage devices. The space occupied by the removed secondary copy is reallocated to store other data.

## REDUCING RESOURCES IN A HIGH RELIABILITY DATA STORAGE SUBSYSTEM

The present invention relates to data reliability in a data processing system, and specifically to a method and apparatus for providing a backup copy· of data stored in a data processing system.

The usefulness of a data processing system obviously depends upon the reliability in which data can be stored therein. This usually means whether the system can maintain data integrity in the presence of failures in its storage devices. In current data processing systems, maintaining data integrity against device failures typically means a system's ability to reconstruct the data during recovery, and such reconstruction is commonly achieved by providing a backup copy of the data in the system.

Methods of maintaining the data reliability in a data processing system will typically be evaluated by such factors as how much loss of system availability would be caused by a device failure, the amount of extra hardware employed by a method, and the amount of interference caused by a method upon normal processing of the system.

In one prior art method of providing data backup in a data processing system, data are duplicated into two separate redundant storage devices in identical storage locations so that the devices are mirror images of each other. Advantageously, this method allows the system to continue processing without substantial interruption when one device fails. The disadvantage of the method, however, is that it doubles the number of devices otherwise needed to store the data.

In another prior art method, data backup is provided by maintaining a continuous log of data (and/or modifications to data) stored in the system. The continuous log is recorded on cheaper archival devices such as magnetic tapes and is used to reconstruct the data during system recovery. Although data backup according to this prior art method is provided with less hardware cost, it has the disadvantage that a long delay will usually be suffered during the reconstruction of data from the log, thus causing significant degradation of the system's availability.

An object of the present invention is to provide a backup copy of data in a data processing system. The backup copy is kept in a manner whereby loss of availability of the system due to a storage failure is minimized, but without a significant increase in hardware cost. SUMMARY OF THE INVENTION

The present invention is a method and apparatus for improving data reliability in a computer system. The invention operates to concurrently store data in duplicates into at least two different redundant intermediate storage devices during a page-out operation. Periodically, duplicate copies of data in the intermediate storage devices are transferred to an archival device and the space in the intermediate storage devices which was occupied by the transferred duplicate copies is then released for use to store new data.

Typically the data that most likely will be accessed by a computer system is the data that has been most recently used and most recently stored by the system. In the present invention, most-recently-stored data are kept in duplicates in the intermediate storage devices. In a preferred embodiment, the intermediate storage devices are direct access storage devices (e.g. magnetic disks). When one intermediate storage device fails, the data that most likely will be accessed by the system would still be present in another intermediate storage device. To minimize the number of intermediate storage devices used for storing redundant data, duplicate data in the intermediate storage devices are periodically transferred to cheaper archival devices. As a result, while the cost of maintaining duplicate copies of data is reduced, the availability of the system remains high.

Fig. 1 is a block diagram of a computer system which embodies the present invention.

Fig. 2 is a block diagram of the control blocks used for managing data storage in the computer system of Fig. 1.

Fig. 3 is a block diagram illustrating means in the preferred embodiment of the present invention.

Fig. 4 shows two page request blocks created to page out a page of a tapeplex or a duplex file.

Fig. 5 shows the relationship between a DSB and the slots assigned to the corresponding file.

Fig. 6 shows a bit map created to transfer copies of tapeplex files to the archival device and a bit map created to erase the secondary copies of the transferred file.

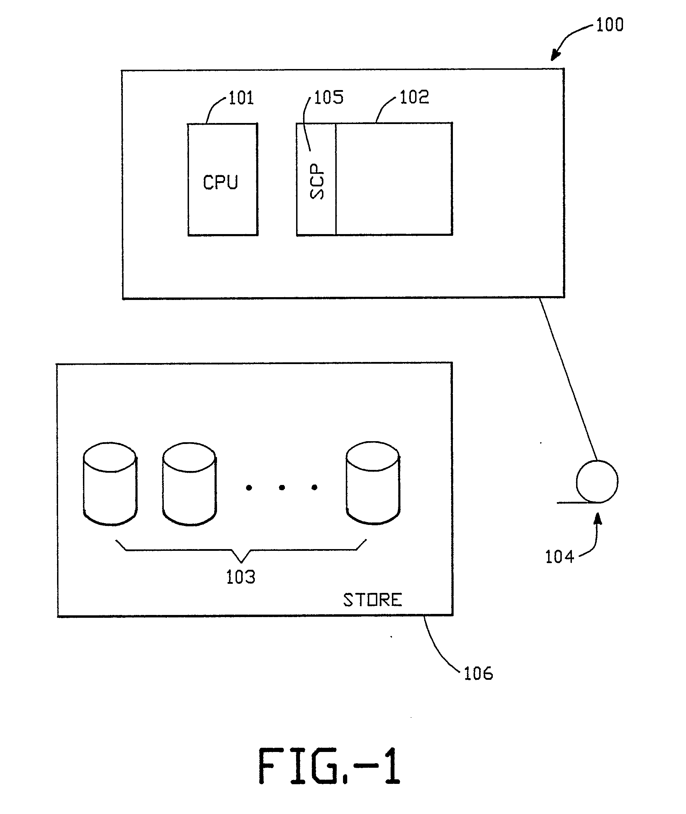

Referring to Fig. 1, it shows a block diagram of a computer system 100 wherein the present invention is embodied. Computer system 100 includes a central processing unit (CPU) 101, a main memory 102, two or more intermediate storage devices 103 and at least one archival device 104.

The CPU 101 of computer system 100 has a similar architecture as the AMDAHL 580, the IBM System/370 described in "System/370 Principles of Operation", IBM Publication number GA22-7085, or the IBM system/370 extended architecture described in "System 370/Extended Architecture Principles of Operation", IBM Publication No. SA22-7085.

The intermediate storage devices 103 have similar access characteristics. In the preferred embodiment,

2

each of these intermediate storage devices 103 is a direct access storage device (e.g. a magnetic disk).

The archival device 104 is typically a mass storage device with a cheaper cost/bit ratio (i.e. the average cost of storing one bit of information) than the intermediate storage devices 103, but whose average access time is longer than the intermediate storage devices 103. One such kind of mass storage device is a magnetic tape. Another such kind of mass storage device is an optical storage device.

In operation, CPU 101 accesses data directly from the main memory 102. The storage space of the main memory 102 is a subset of the storage space of the intermediate storage devices 103. When a storage location accessed by the CPU 101 is not present in the main memory 102, that storage location will be paged in from the intermediate storage devices 103 to the main memory 102. Conversely, when free space in the main memory 102 is needed, selected portions of the main memory 102 will be paged out to the intermediate storage.devices 103 so that the locations of the paged-out data can be reallocated to store other data.

Computer system 100 operates under the control of a system control program (SCP) 105 which resides in the main memory. SCP 105 has a similar architecture as the IBM Multiple Virtual Storage (MVS) operating system or the IBM Virtual Machine (VM) operating system. It includes facilities to schedules user and system tasks operating in the computer system 100. It also includes facilities for performing input/output operations between the CPU 101 and the intermediate storage device 103, and between the CPU 101 and the archival device 104. The present invention is embodied in the SCP 105 as an improvement thereto.

Each storage device 103 is also referred to as a "volume". Several volumes 103, as shown in Fig. 1, are collectively referred to as a "store" 106. Although one "store" 106 is shown in Fig. 1 and described in the preferred embodiment, it is obvious that computer system 100 can have more than one store.

The storage space of each volume 103 is partitioned into a plurality of "slots" with the same predefined size (e.g. four kilobytes per block). Each data file in the computer system 100 is partitioned into one or more pages so that each of which will be stored into a slot.

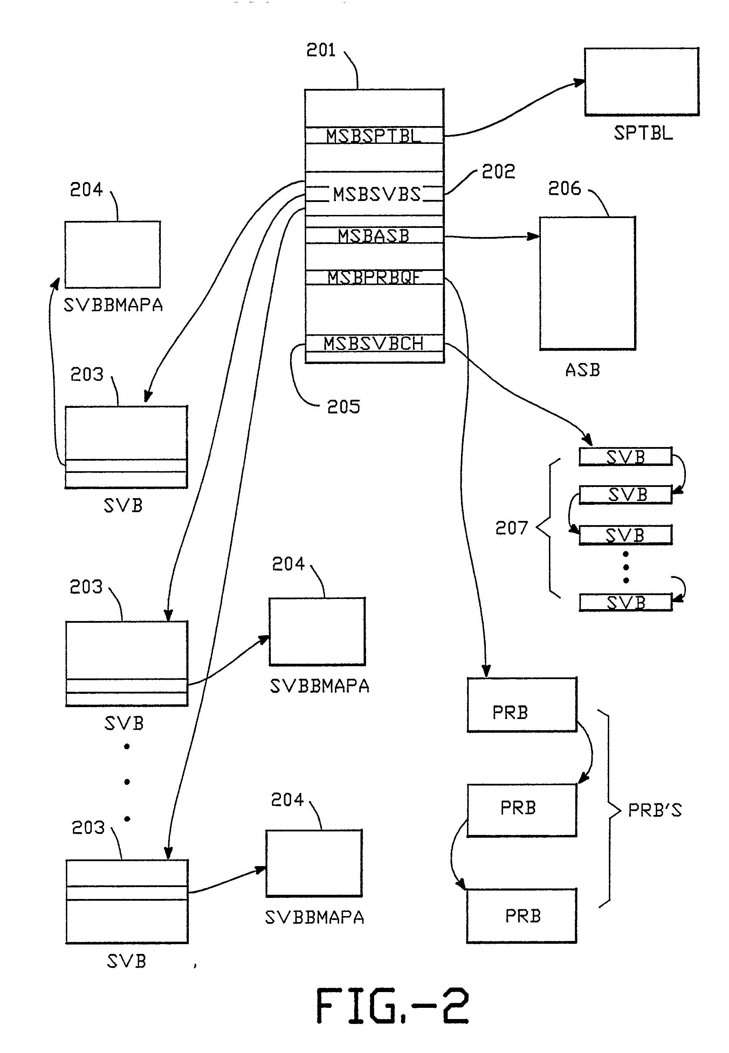

Fig. 2 illustrates the control blocks used by the SCP 105 for managing data storage in the computer system 100. At a predefined location in the main memory 102, a control block MSB (Mounted Store Block) 201 is provided. MSB 201 contains information which is used by the SCP 105 when it accesses the volumes 103 of the store 106.

The MSB 201 in the preferred embodiment includes a plurality of pointers, MSBSVBS 202, each of which points to a control block SVB (Store Volume Block) 203. Each SVB 203 contains information used by the SCP 105 for accessing an individual volume 103. Each SVB 203 has a field whereby a bit map, SVBBMAPA 204, corresponding to the volume can be accessed. The bit map SVBBMAPA 204 is stored as one or more pages in the volume and will be paged into the main memory 102 when it is used. Each bit in a SVBBMAPA 204 corresponds to an individual slot of the corresponding volume 103 and identifies which slot in the volume 103 is free and which is occupied. Thus, if the storage space of a volume 103 is divided into 4024 slots, its SVBBMAPA 204 will have 4024 bits. When a slot in a volume 103 is allocated to a data file, the corresponding bit in its SVBBMAPA 204 will be set to a "0". Conversely, when a slot in a volume 103 is free, its corresponding bit in the SVBBMAPA 204 will be set to a "1". The position of a bit within the SVBBMAPA 204 is a function of the position of the corresponding slot within the corresponding volume 103 (e.g. the first bit corresponds to the first slot, the second bit corresponds to the second slot, etc) so that the location of a given slot in volume is determinable from the position of its corresponding bit in SVBBMAPA 204.

The vacancy of a volume 103 is a function of the number of free slots in the volume 103. Conversely, the fullness of a volume 103 is a function of the number of allocated slots in the volume 103. Both the vacancy and the fullness of a volume 103 can be determined from its corresponding SVBBMAPA 204.

Periodically in the preferred embodiment, the SVBBMAPA's 204 of all the volumes 103 are scanned by the SCP 105 to determine their respective vacancies. The SCP 105 then ranks the volumes 103 based upon their respective vacancies and arranges a queue of SVB's 207 which chained to a pointer MSBSVBCH 205 in the MSB 201 so that the position of a SVB within the queue 207 depends upon the number of "1" bits in the corresponding SVBBMAPA of the volume.

The MSB 201 also has a pointer to a Table of ASB (Address Space Block) 206. The ASB 206 contains a plurality of fields wherefrom a plurality of DSB's (Data Space BLocks) can be accessed. Each DSB describes a data file being kept in the store 106, and includes the following fields:

(1) A DSBID field - This field contains the identification of the file to which the DSB is assigned;

(2) A DSBFLAG field - When the DSBFLAG is set to either a first predefined value ("DSBDUPLX"-duplex) or a second predefined value ("DSBTPLX"-tapeplex), it means that duplicate copies, a primary copy and a secondary copy, of the corresponding file are kept in the store 106. A "DSBDUPLX" value or a "DSBTPLX" value in the DSBFLAG also means that a copy of the file may be periodically transferred into the archival device 104. For a DSBTPLX file, however, the storage space occupied the secondary copy will be freed for reuse after the copy is written into the archival device.

(3) A DSBSLOT field - This field contains four words. Each of these four words can be used to store a pointer to a slot location within the store 106 which contains a page of the corresponding file. If the DSB belongs to either a DSBDUPLX" file or to a "DSBTPLX" file, half of the used DSBSLOT words will contain pointers to slots that store the primary copies, and the other half will contain pointers to slots that store the secondary copies. When a file requires more than four slots, one or more space extension, DSX's, will be added to the DSB. For non-DSBDUPLX and non-DSBTPLX files, the last of the four words in the DSBSLOT field will point to the DSX. For DSBDUPLX and DSBTPLX files, all four words in the DSBSLOT will be used to point to four DSX's.

(4) A DSBSIZE field - This field contains the number of slots being used to store the file. The SCP 105 can determine whether a DSX has been added to the DSB by examining the DSBSIZE field.

To create a file, an "open file" command will be issued. An open file command contains an identification that is given to the file, the size of the new file to be created and whether the new file is a duplex (DSBDUPLX) or in tapeplex (DSBTPLX) file.

In response to an open file command, the SCP 105 obtains a DSB from the ASB 206 of the store 106. When a DSB is allocated, the SCP 105 puts the identification of the new file into the DSBID field and set the DSBFLAG to reflect whether the file is tapeplex or duplex. Also, based upon the specified size of the file, the SCP 105 sets the DSBSIZE field to reflect the number of slots needed for the file and allocates DSX if the DSBSLOT is not large enough.

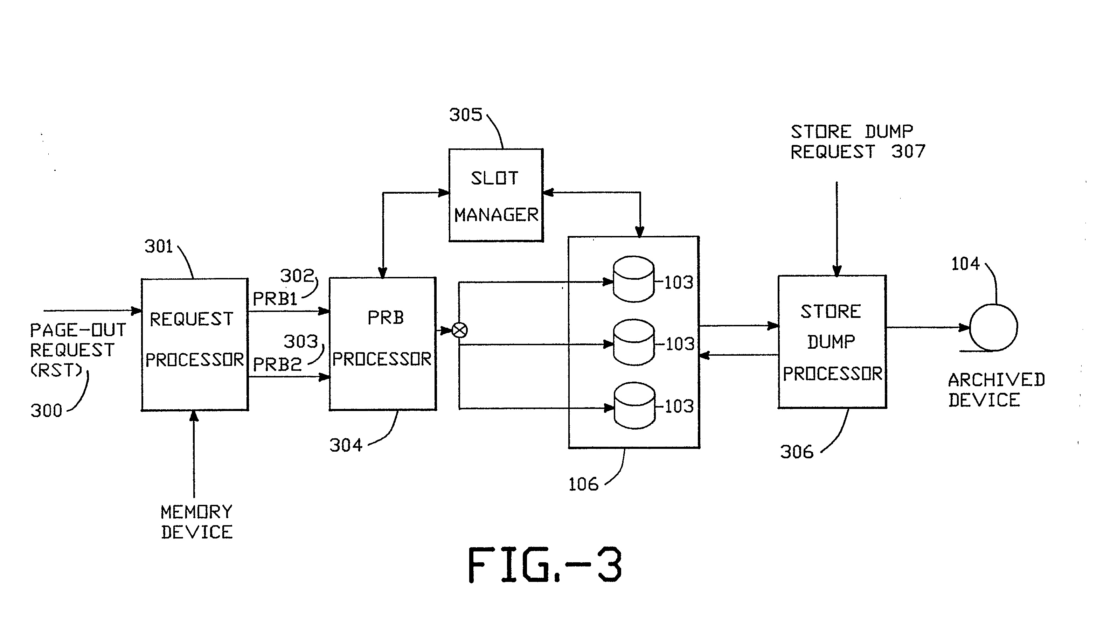

Fig. 3 is a block diagram illustrating the components in the preferred embodiment for processing a page-out operation and for dumping duplicate copies in the store 106 to the archival device 104. In a page-out operation, designated locations from the main memory 102 are transferred to the store 106. The SCP 105 initiates a page-out process by creating a real storage block (RST) 300 wherein is contained the main memory location of the page out file, along with other information, including the information from the DSB of the file.

The RST 300 is received by a request processor 301. The request processor 301 is implemented in the preferred embodiment by a IBM/370 computer program executing within the computer system 100.

Table 1 illustrates a IBM System/370 assembly program listing which forms part of the request processor 301 code for performing a page-out process of a tapeplex file to a non-specified slot in the store 106.

4

Table 1

| | | |
|---|---|---|
| 1.1 | L | R15, = A(BLDPRB) |
| | BALR | R14,R15 |
| | ST | R1,JSAR1 |
| | LR | R2,R1 |
| | USING | PRB,R2 |
| FILLPRBO | DS | OH |
| | LR | R14,R4 |
| | MVI | PRBRW,X'05' |
| 1.2 | JRSTREAL | R14 |
| | ST | R14,PRBRSA |
| | AH | R14, = V(2048) |
| | ST | R14,PRBRSA2 |
| | MVC | PRBPRB(4),RSTPRB |
| 1.3 | ST | R2,RSTPRB |
| 1.4 | OI | RSTFLAG,RSTPGIO |
| 1.5 | BAL | R14,PAGRQ |
| 1.6 | @IF | (TM,RSTFLAG,RSTDUPLX,O), |
| | | AND, (CLC,MSBVOLN,NE, = H'1'), |
| | | AND, (TM,PRBFLG,PRBDUPLX,Z) |
| 1.7 | L | R15, = A(BLDPRB) |
| | BALR | R14,R15 |
| | LR | R2,R1 |
| 1.8 | OI | PRBFLG,PRBDUPLX |
| | B | FILLPRBO |
| | @ENDIF | |

Referring to Table 1, upon receiving the RST 300, the request processor 301 first requests space to build a first page request block (PRB1) 302 for each page of the file (line 1.1). For each PRB1, the request processor 301 transfers the main memory location of the corresponding page from the RST 300 to the PRB1 (lines 1.2-1.3). The SCP 105 then freezes the page (line 1.4) to prevent it from being changed during the page out. A link is also established between each PRB1 and the RST 300. The PRB1 302 is then chained to the PRB queue off the MSB (line 1.4).

If: (a) the DSB of the file indicates that the page belongs to a duplex file, (b) there are more than two volumes in the store 106 and (c) only one PRB has been built for the page, then, a second PRB, PRB2 303, for each page of the file will be built (lines 1.6-1.7). A PRB flag, PRBFLAG, within each PRB2 303 is set (line 1.8) to (PRBDUPLX) indicate that this is a second PRB for the page.

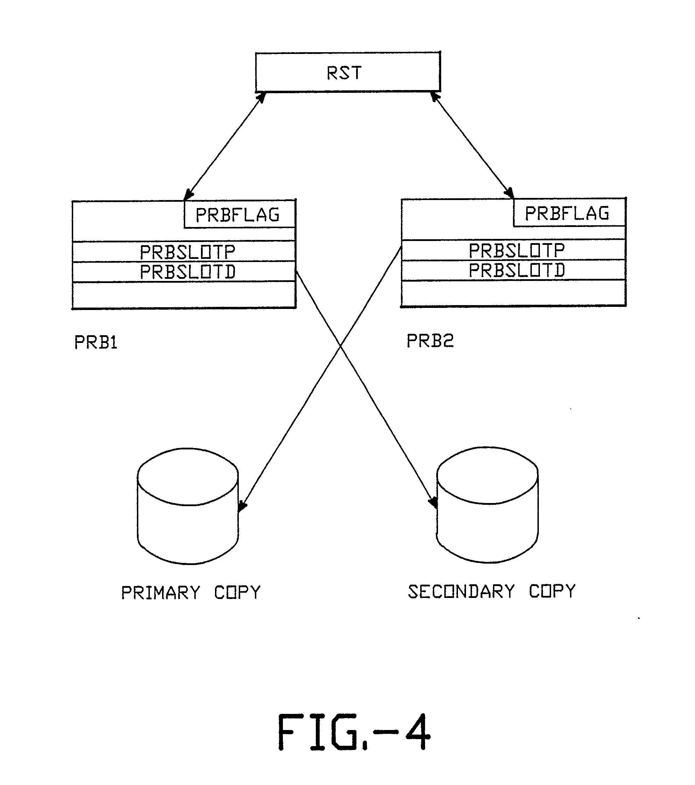

Fig. 4 illustrates two PRB's, PRB1 and PRB2, that correspond to a page of a tapeplex file. A flag, PRBFLAG, in PRB1 is set to indicate that it is created to request a slot which is used to store a primary copy of the page. The flag PRBFLAG of PRB2 is set to PRBDUPLX to indicate that it is created to request a slot which is used to store a secondary copy of the same page. Each of the two PRB's has a link to the RST of the page. Two pointers, PRBSLOTP and PRBSLOTD, are included in the PRB's to indicate the respective locations of the counterpart slots. Thus, if a slot is assigned to the secondary copy, that slot location will be stored in the PRBSLOTD field of PRB1, and if a slot is assigned to the primary copy, that slot location will be stored in the PRBSLOTP field of PRB2.

Each of PRB1 302 and PRB2 303 are received by a PRB processor 304. The PRB processor 304 is implemented as a computer program executing within the computer system 100. Whenever a volume 103 within the store 106 is idle, the PRB processor 304 will start processing the chain of PRB's queued to the MSB. The PRB processor 304 takes the first PRB and checks whether any slot or volume has been specified for the PRB. Assuming, for the purposes of illustration, that neither a volume nor a slot address has been specified for the file created above. The PRB processor 304 then goes through the chain 207 of volumes queued to MSBSVBCH and finds the first idle volume in the store 106. Because the SVB's are chained in the order of their respective vacancies, this also means that an idle volume with the highest vacancy is located. When a device is found, the PRB processor will enter into a part of the PRB processor 304 program illustrated in the IBM system/370 assembly code of the following Table 2.

## Table 2

```
TRYPO        LA        R3,MSBSVBCH-(SVBSVB-SVB)
             SR        R4,R4
2.1          @IF       (TM,PRBFLG,PRBDUPLX,O)
2.1a           L       R4,PRBSLOTP
               SRA     R4,20
               BZ      TRYCC1
2.2          @ENDIF
2.3          @DO    WHILE,(LT,R3,SVBSVB,NZ)
             L     R15,SVBIOR+IORDEVT-IOR
             @IF    (TM,SVBFLG,SVBNSPAC+SVBIOGN,Z),
                    AND,
                    (TM,DEVFLG2-DEV(R15),(DEV2NOP,Z),
2.4                 AND,(CH,R4,NE,SVBVLNUM)
                    B     TRYPOV
             @ENDIF
```

```
     2.5                     @ENDDO
                             B           TRYCC1
                             SPACE       2
               TRYPOV        JSAVE       R1,REGBASE=R13
                             @IF         (TM,PRBFLG,PRBDUPLX,O)
                                L        R4,PRBSLOTP
                               SRA       R4,20
                               @BZ       TRYPOV1
                                  CH     R4,SVBVLNUM
                                  BE     TRYPOV1
                             @ELSE
                                L        R4,PRBSLOTD
                               SRA       R4,20
                               @IF       NZ
                                  CH     R4,SVBVLNUM
                                  BE     TRYPOV1
                               @ENDIF
                             @ENDIF
                             L           R4,PRBRSA
                             JREALRST    R4,WORK=R14
     2.6                     JMCAL       SLPOT
                             BNZ         TRYPOV1
     2.7                     @IF         (TM,PRBFLG,PRBCNCL,O)
                               JMCAL     SLPUT,(R5),(R1)
                               B         TRYPOV3
     2.8                     @ENDIF
     2.9                     @IF         (TM,RSTFLAG,RSTFDPLX,0),AND
                                         (CLC,MSBVOLN,NE,=H'1')
                                L        R14,RSTPRB
                               @DO       WHILE,(LTR,R14,R14,NZ)
                                  @IF    (TM,PRBFLG,PRBDUPLX,Z)
                                     ST  R1,PRBSLOTD-PRB(R14)
                                  @ELSE
                                     ST  R1,PRBSLOTD-PRB(R14)
                                  @ENDIF
                                   L     R14,PRBPRB-PRB(R14)
                               @ENDO
```

```
2.10            @ENDIF
                ST          R1,PRBSLOT
2.11            BAL         R14,CNVTSLT2
```

In the first instruction, the first volume in the SVB chain 207 is fetched. From lines 2.1 to 2.2, the PRB is checked to see whether it is for a primary or a secondary copy. Moreover, if the PRB is for a secondary copy, then a check is made to see whether the primary copy has been allocated a slot. The secondary PRB will be processed only when the primary PRB has been allocated a slot.

In processing a PRB1, which is the PRB created for the primary copy of a page, the PRB processor 304 allocates a slot to the PRB in the first device that is available and operational (lines 2.3-2.5). The PRB processor 304 gets a slot for the PRB by calling the slot manager 305 (line 2.6), passing to the slot manager the SVB of the chosen volume.

The slot manager 305 is also implemented as an IBM System/370 computer program executing within the computer system 100. Part of the slot manager 305 program for allocating a slot in a given volume is illustrated in the following Table 3.

## Table 3

```
3.1     L       R1,SVBBMAPA(R5)     Get the virtual address
```

```
        JMCAL     MPFET            See if it is around
        BZ        POTNOBMP         Page not in yet
        LA        R15,7(R7)        Round slot number up
        BAL       R14,SLPUTCK      Check for pending purges
        BNZ       POTPUTER         Bad bit map?
        CH        R6,=H'8'         a byte to look at?
        LA        R4,7             Mask for bit number
        LA        R2,X'FF'         Set up for a mask
        BL        POTCYSK6
        N         R15,=X'00007FF8' Extract low bit number
        LA        R14,0(R6,R7)     Point at last slot
        @IF       ZERO             A fragment of a byte?
          LR      R15,R7
          N       R15,=X'00007FF8' Was it really zero
          @IF     NZ               It really is a fragment
            LR    R15,R1
            A     R15,=F'4096'     Point past last byte
            LNR   R0,R2            Set flag: 2nd page needed
            B     POTCYSK7
          @ENDIF
        @ENDIF
        N         R14,=X'00007FF8' Extract high bit number
        SR        R14,R15          Is high bit on same page?
        LR        R0,R14           Save value
        @IF       MINUS        If R14<R15 it crosses a page
          L       R14,=X'00008000'
          SR      R14,R15          Get count to end of page
        @ENDIF
        SRDL      R14,3            Get byte numbers
        AR        R15,R1           Point at first byte
        BCTR      R14,0            Reduce for EX
        EX        R14,POTTRT       Look for a bit
3.2     BNZ       GOTBIT           So much for the TRT!
POTCYSK7 DS       0H
3.3     NR        R4,R7            Get the bit number
        LR        R1,R15           Get that first byte
        BZ        POTCYSK2         Exact hit
```

9

```
          BCTR      R1,0                        Back to partial one
          SRL       R2,0(R4)                    Generate a mask
          IC        R4,0(R1)
          NR        R2,R4                       Extract the byte
          BZ        POTCYSK2                    No, go check out tail end
POTCYSK5  LA        R4,TRTTAB(R2)
          IC        R2,0(R4)                    Go get it
          B         GOTBIT                      Go take it
POTCYSK2  LTR       R0,R0                       Lap over into next page?
          LA        R1,1(R14,R15)               Point at last byte
          BM        POTCYSK1                    Yes, look in next page
POTCYSK6  LA        R14,0(R6,R7)
          L         R2,=X'0000FF00'             Prepare to create a mask
          N         R14,-F'7'                   Get number of bits left
          SRL       R2,0(R14)                   Get the mask
          IC        R14,0(R1)
          NR        R2,R14                      Look for a bit
          BNZ       POTCYSK5                    Yes, go use it
          BR        R10                         Cylinder is full
POTPUTER  L         R5,SVBMSB                   Make the store read only
          B         SLPERR
POTNOBMP  MVI       JSAR1,X'FF'                 Show bitmap not in
POTCYSK1  AR        R6,R7                       Get number of last slot
          A         R7,=X'00008000'            Round up
          N         R7,=X=FFFF8000'            Get page boundary
          SR        R6,R7                       Get number to be done
          BP        POTCYSK4                    Go retry with those values
          SR        R1,R1                       Set cc
3.4       BR        R10
GOTBIT    EQU       *                           R1->byte,R2=bit number +1
3.5       BCTR      R2,0                        Reduce bit number
          LR        R14,R1                      Save byte pointer
          N         R1,=X'0000FFF'             Get page offset
          ICM       R5,B'0110',SVBVLNUM        Add volume number
          L         R0,SVBTSCNT                 Get T-slot count
          SLL       R1,3                        Build page number
          SLL       R5,12                       Restore high bits
```

```
        A          RO,=F'1'
        OR         R1,R2
        A          R2,=V(BITSOFF)      Point at bit mask
        ST         RO,SVBTSCNT         Increment T-slot count
        OR         R1,R5               Finish the slot number
        NC         0(1,R14),0(R2)      Allocate the slot
        ST         R1,JSAR1
        SR         R15,R15             Set return code
3.6     B          POTRET              return
POTTRT  TRT        0(*-*,R15),TRTTAB   Look for a bit that's on
TRTTAB  JC         AL1(0,8,7,7,6,6,6,6,5,5,5,5,5,5,5,5)
        DC         16AL1(4),32AL1(3),64AL1(2),12BAL1(1)
```

From lines 3.1 to 3.2 of table 3, the free/allocate bit map SVBBMAPA of the given volume is fetched.

In the preferred embodiment, the slot manager 305 searches the bit map starting from the bit address that corresponds to the disk cylinder which is currently being accessed. Starting from that bit position, the slot manager 305 looks at the bit map SVBBMAPA to search for a free slot that has a value of "1" (Lines 3.3-3.4). After a free slot is selected from the bit map SVBBMAPA, the slot manager 305 will turn off the corresponding bit in the bit map SVBBMAPA, generate the address of the assigned slot from the selected bit and return the slot address (which is saved in R1)to the PRB processor 304.

Referring back to Table 2, when the PRB processor 304 receives the requested slot, it inspect the PRBFLAG to makes a final check to see whether the page out request has been cancelled (lines 2.7-2.8). The PRBFLAG will be set to a value "PRBCNCL" if SCP 105 decides to cancel the request. If the request has been cancelled, the slot will be returned.

If the page request has not been cancelled, the PRB processor 304 will check whether the PRB belongs to a duplex file by looking at the corresponding RST. If yes, the PRB processor 304 puts the assigned slot location into the PRBSLOTP field of PRB2 (lines 2.9-2.10). When finished, the PRB processor 304 translates the assigned slot number into an address within the assigned storage device 103 such as a cylinder address, a head address and a track address and stores it into PRB1.

After the PRB1 is built, it is chained to a PRB queue off the SVB of the selected volume. When the volume becomes idle, the PRB processor 304 will process the PRB queue. The PRB processor 304 builds a channel program from the address and write the page to the volume. After the page is written into the assigned slot, the slot address is stored into the corresponding DSBSLOT entry in the file' DSB

In the preferred embodiment the PRB processor 304 also sorts the PRB's so as to minimize rotational delay when writing into a volume. This is performed by sorting all of the PRB's in the SVB page-out queue into ascending record number order. The PRB processor 304 then chooses the first PRB of the chain to be the PRB of the largest gap in the record numbers between successive records.

The PRB processor 304 processes PRB2 in a similar way as it processed PRB1. Referring again to Table First, the PRB processor gets PRB2 from the MSB queue. Since neither volume nor slot was specified in PRB2, PRB processor will go down the SVB chain to find the first available and operational device for the PRB. However, because the PRBDUPLX field of PRB2 indicates that it belongs to the secondary copy of a duplex file (line 2.1), the PRB processor 304 will get the slot address assigned to the primary copy (2.1a) and performs an additional check to make sure that volume chosen for PRB2 is not the same volume as PRB1 (line 2.4).

When the volume is chosen, a slot is chosen and the page is written to the chosen slot in a similar manner as described about for PRB1. At the end, therefore, two copies of the same page will written with each copy written into a separate volume in the store 106. When finished, the assigned slot locations are stored in the RST which which be used in a page-in operation.

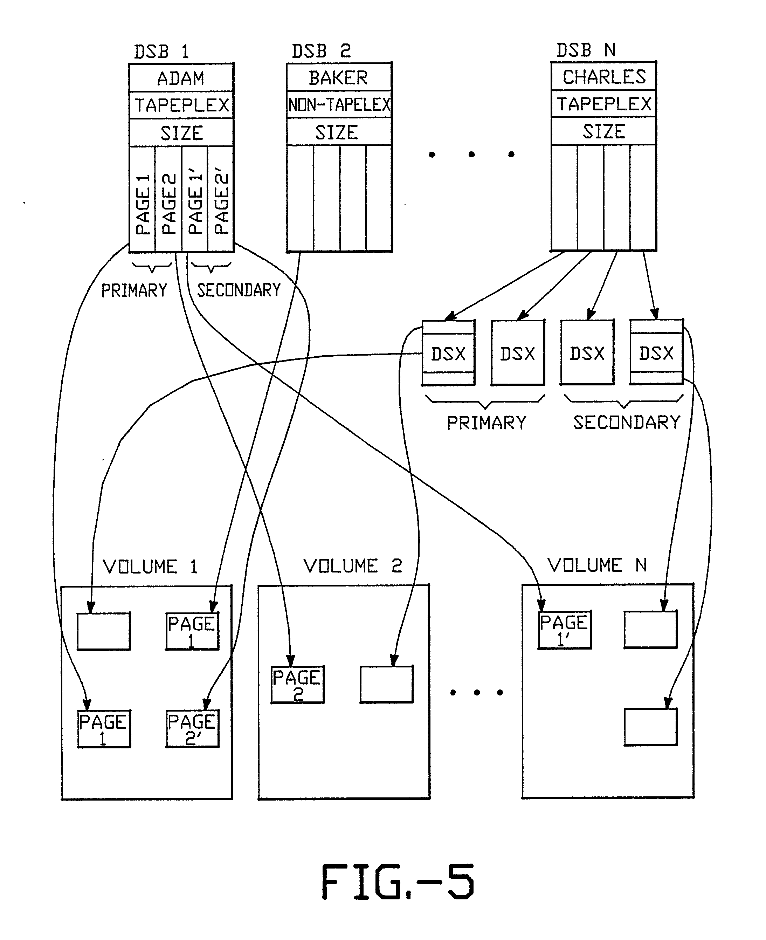

Fig. 5 illustrates the relationship between the DSB's and the slots of the store 106. Illustrated in the figure is a first DSB (DSB1) which belongs to a tapeplex file having an identification of "ADAM" and which has two pages. Two entries in the DSBSLOT field are used to point to slot locations, page 1 in volume 1 and page 2 in volume 2, which contain the primary copies of the file pages. Two other entries in the DSBSLOT field are used to point to slot locations, page 1' in volume 2 and page 2' in volume m, which contain the secondary copies of the file pages. Fig. 5 also illustrates a second DSB (DSB2) of a simplex file identified as "BAKER" which has only one page and therefore only one DSBSLOT field is used. Fig. 5 also illustrates a third DSB (DSB's) of a tapeplex file ("CHARLES") which has more than two pages, and therefore a plurality of DSX's are assigned.

Referring back to Fig. 3, there is shown a store dump processor 306 will be initiated occasionally to transfer secondary copies in the store 106 to the archival device 104 to free up storage space in the store 106. The store dump manager in the preferred embodiment is implemented as a computer program executing within the computer system 100.

The store dump processor 306 may be initiated by a store dump request 307 entered by a system operator, or by program written for that purpose. The store dump processor 306 may be initiated when the free space in the store 106 has fallen below a predefined minimum, or it may be initiated regularly, such as one a week at a predefined time instance. When the store dump processor 306 is initiated, it first sets a lock to the bit maps SVBBMAPA's of the store 106 so that they would not be changed during the dump process. The store dump processor 306 also waits for all commit activities to finish.

Once these two conditions have been met, the store dump processor 306 performs a sequence of operations which includes the IBM System/370 assembly code illustrated in the following Table 4.

## Table 4

```
.
   .   .
       .
       .
```

```
4.1      USING  DSB/R7
         LA  RB,1  Number of DSBXS in a page
         @IF  (CLI,DSBTYPE,NE,C'X')
         LA  R8,4096/L'DSB          Number of DSBs in a page
         @ENDIF
         @DO  WHILE,(BCT,R8)        Loop through them
         L  R9,SVBDUMP              Point at DCB again
         USING  DCB,R9
         @IF  (CLI,DSBTYPE,NE,C'F'),  Is it allocated?
              ANDIF,(TM,DSBFLAG,DSBDUPLX,O),  And duplexed?
              ANDIF,(TM,DSBFLAG,DSBTPLX,O),   And tapeplexed?
              OR,(CLI,DCBID,EQ,C'D')  Or not TAPEDONE scan?
         DROP  R9
         LA  R9,DSBSLOT
         LA  R10,2                  Number of pairs
         @IF (CLI,DSBTYPE,EQ,C'P')
         LA  R9,DSXSLOTS-DSX(R7)
         LA  R10,(4096-(DSXSLOTS-DSX))/8  No. of pairs
```

```
4.2        @ENDIF
           @DO   WHILE, (BCT,R10)
           @IF   (LT,R1,0(R9)MNZ),       Get primary lot
                 ANDIF,(C,R1,NE,=X'7FFFFFFF') Damaged?
           @IF   (CLI,DSBINDX+1,NE,0)    Is this an index page?
           JMCAL SCNID,,(R1)             Yes, scan it
           @ENDIF
4.3        L  R15,SVBDUMP                Point at the DCB
           USING DCB,R15
           @IF   (CLI,DCBID,NE,C'd')     Do for dump start only
           DROP  R15
           L  R1,0(R9)                   Get the slot ID back
           N  R1,=A(SLOTVOL)             Extract volume
           SRL R1,20-2                   Volume number times four
           L  R2,MSBSVBS(R1)             Point at his SVB
           L  R2,SVBDUMP-SVB(R2)         Get the DCB
           L  R1,0(R9)                   Get slot ID again
           N  R1,=A(SLOTSLOT)            Get slot ID
           SRL R1,3                      Divide by eight
           A  R1,DCBSLOT-DCB(R2)         Get page number
           L  R0, CURRHOME
           JMCAL PFIX,(R0),(R1)          Nail it down
           LTR R15,R15
           BNZ TPSCANER
           LTR R1,R1                     Get real address
           BNP TPSCANER
           L  R2,0(R9)
           N  R2,=A(7)                   Get the bit number
           A  R2,=V(BITSOFF)
           NC  0(1,R1),0(R2)             Turn it off
           JMCAL PFREE,0,(R1)
4.4        @ENDIF
4.5        @IF (TM,DBFLAG,DSBTPLX,0),  Is it tapeplexed?
                 ANDIF,(LT,R1,4(R9),NZ), With a duplex copy?
                 ANDIF,(C,R1,NE,=X'7FFFFFFF') In good shape?
           N  R1,=A(SLOTVOL)             Extract volume
           SRL R1,20-2                   Volume number times four
```

```
L R2,MSBSVBS(R1)            Point at his SVB
L R2,SBVDUMP-SVB(R2)        Get the DCB
USING DCB,R2
L R1,4(R9)                  Get slot ID again
N R1,=A(SLOTSLOT)           Get slot ID
SRL R1,3+12                 Get page number
SLL R1,2                    Times four
L R1,DCBBMAP(R1)            Get MWP number
JMCAL MPGET,,(R1)           Get the page
L R0,4(,R9)                 Get the slot ID again
N R0,=A(4095*8)             Get byte number
SRL R0,3
AR R1,R0                    Point at the byte
L R15,4(,R9)               Slot number one last time
N R15,=A(7)                 Get bit number
A R15,=V(BITSON)
@IF (CLI,DCBID,EQ,C'd'),    TAPEDONE?
IC R3,0(R1)                 Get the bit
@EX TM,R3,0(R15)            Check the bit
@IF NZ                      Bit still on?
LR R4,R1                    Save where bit goes
L  R1,4(,R9)               Free the duplex copy
LR R0,R5                    Get the MSB
JMCAL SLPUP,(R0),(R1),L=YES
STC R3,0(R4)               Restore the bit
XC 4(4,R9),4(R9)           Clear it out
L R4,JSAR4
USING RST,R4
OI RSTFLAG,RSTMOD           Show changed
DROP R4
@ENDIF
@ELSE,                      Not TAPEDONE
OC 0(1,R1),0(R15)          Set the bit
@ENDIF
DROP R2
4.6    @ENDIF
@ENDIF
```

```
LA R9,8(,R9)                To next pair
@ENDDO    , Loop through slot pairs
@ENDIF
LA        R7,L·DSB(R7)      Move to next one
@ENDDO
```

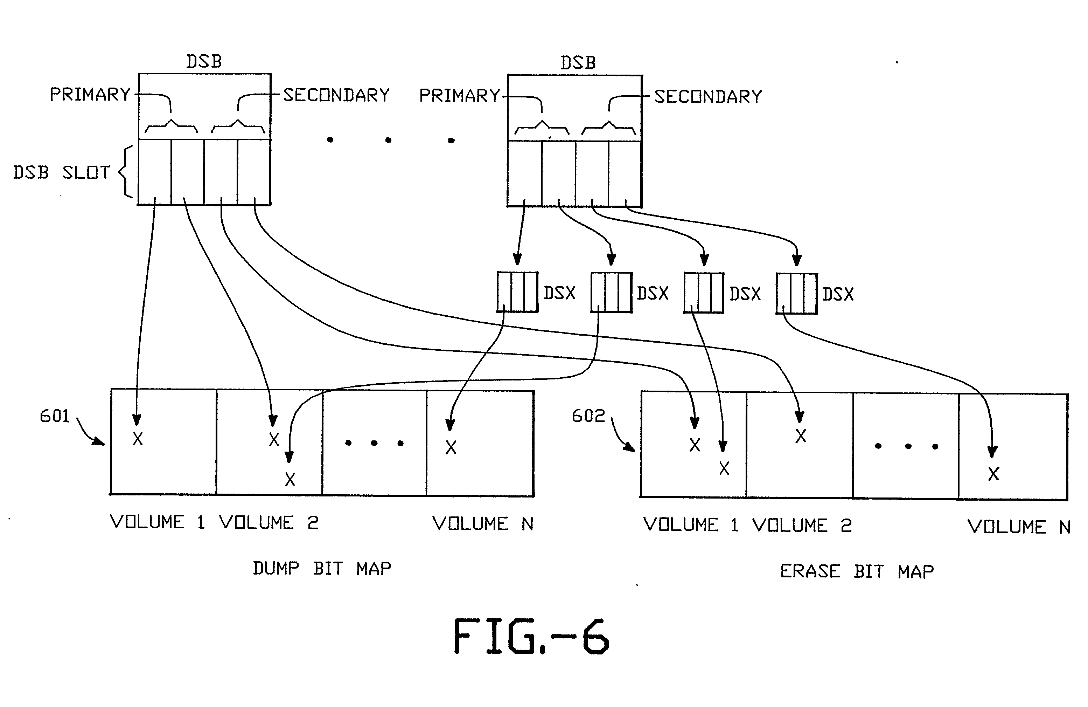

Referring the Table 4 and Fig. 6, the store dump processor 306 first allocates storage space wherein it creates two composite bit maps, a dump bit map 601 and a erase bit map 602. The manner in which the space is allocated is commonly known in the art and therefore need not be discussed here. Each of the bit maps 601 and 602 has a section reserved for each volume of the store 106.

From lines 4.1 to 4.2 of Table 4, the store dump processor 306 scans sequentially through the DSB's of the store 106 to identify those DSB's that belong to either a tapeplex or a duplex file. For each slot that belongs to a tapeplex or a duplex file, the store dump processor 306 uses the primary slot address in the DSBSLOT field to set the corresponding bit in the dump bit map 601. (lines 4.3 to 4.4) Each section of the dump bit map 601 is included in a dump control block (DCB) which is linked to the SVB of the corresponding volume.

From lines 4.5 to 4.6, the store dump processor 306 also uses the secondary slot address in the DSBSLOT field to set a corresponding bit in the erase bit map 602 for each slot of a tapeplex file.

After the store dump processor 306 has gone through all of the DSB's of the store 106, it then looks at the SVB of each volume and uses the DCB to dump the slots identified by the dump bit map 601 into the archival device 104. When this is finished, the store dump processor 306 then uses the erase bit map 602 to set bits in the allocate/free bit map SVBBMAPA of each volume to free up the slot occupied by the secondary copies of the tapeplex file.

When a failure occurs in a volume, the SCP 105 can access the tape and reconstruct the data of the failed volume. In reconstructing a volume, data is read from the tape. The SCP 105 then allocates slots in the storage devices to store the data as though it is creating a new data file.

The foregoing description of the preferred embodiment of the present invention has been presented for the purpose of illustration and description. It is not intended to be exhaustive or to limit the invention to the precise form disclosed. Obviously, many modifications and variations will be apparent to practitioners skilled in the art. The embodiment was chosen and described in order to best explain the principles of the invention and its practical applications, thereby enabling others skilled in the art to understand the invention for various embodiments and with various modifications as such suit to the particular use contemplated. It is intended that the scope of the invention be defined by the accompanying claims and its equivalents.

**Claims**

1. In a staged storage computer system having a central processing unit and a main memory wherein said central processing unit operates on data in said main memory and wherein data stored in said main memory is paged in from and paged out to a secondary storage subsystem, the secondary storage subsystem including at least two storage devices having similar access characteristics, a method for improving the storage reliability of said secondary storage subsystem, comprising the steps of:
    a. during a page out operation:
a.1. storing a primary copy of data of the page out operation into one of the storage devices of the secondary storage subsystem;
a.2. concurrently storing a secondary copy of the data into a different one of the storage devices in the secondary storage subsystem:
    b. transferring secondary copies in the storage devices of the secondary storage subsystem to an archival device periodically; and
    c. making storage space in the storage devices occupied by the transferred secondary copies available for storing new data.
2. A method as in claim 1, including the steps of providing and maintaining a directory to identify locations in a storage device containing primary copies and secondary copies of data.

3. A method as in claim 2, including the step of building a store dump map based upon the directory, the store dump map identifying locations of data in a storage device which will be transferred to the archival device.

4. A method as in claim 3, including the steps of providing and maintaining an usage map, the usage map identifying locations within a storage device that are free and locations within a storage device that are occupied.

5. A method as in claim 4, including the steps of using the directory to reset locations occupied by the transferred secondary copies from occupied to free.

6. A method as in claim 1, including the steps of ranking the storage devices periodically as a function of the respective amount of vacant locations in the storage devices and selecting a storage device having the highest vacancy to store a primary copy in said step a.1 of claim 1.

7. A method as in claim 1, wherein each of storage devices is a direct access storage device.

8. A method as in claim 1, wherein the archival device is a magnetic disk.

9. In a staged storage computer system having a central processing unit and a main memory wherein said central processing operates on data directly accessed from said main memory and wherein data stored in said main memory is paged in from and paged out to a secondary storage subsystem, apparatus for improving the storage reliability of said secondary storage subsystem, comprising:

a. at least two storage devices with similar access characteristics;

b. an archival device;

c. input means for receiving a page out request

d. first means responsive to send input means for storing a primary copy of data being paged out into one of said storage devices during a page out process;

e. second means responsive to said input means for storing a secondary copy of the data into a different one of said storage devices during the page out process;

f. third means for periodically transferring secondary copies in said storage devices to said archival device; and

g. fourth means coupled to said third means for making storage space of the transferred secondary copies available for storing new data.

10. The apparatus as in claim 9, including a directory means and means for maintaining said directory means to identify locations within the storage device that are free and locations within the storage device that are occupied.

11. The apparatus as in claim 10, including a first mapping means and means for set said first mapping means to identify locations of data in a storage device which will be transferred to the archival device.

12. The apparatus as in claim 11, including a second mapping means and means for setting said second mapping means to identify locations within a storage device that are free and locations within a storage device that are occupied.

13. The apparatus as in claim 12, including means responsive to said directory means for resting said second mapping means so that locations occupied by the transferred secondary copies are reset to free.

14. The apparatus as in claim 9, including means for ranking the storage devices periodically as a function of the respective amount of vacant locations in the storage devices and means selecting a storage device having the highest vacancy to store a primary copy.

15. The apparatus as in claim 9, wherein each of the storage device is a direct access storage device.

16. The apparatus as in claim 9, wherein the archival device is a magnetic tape.

16

FIG.-1

FIG.-2

FIG.-3

EP 0 351 109 A2

FIG.-4

FIG.-5

FIG.-6

EP 0 351 109 A2